# FASCICULE DE BREVET EUROPEEN

(11) **EP 0 660 331 B1**
(45) Date de publication et mention de la délivrance du brevet: **14.04.1999**
(21) Numéro de dépôt: 94470041.8
(22) Date de dépôt: 21.12.1994
(51) Int. Cl.: G11C 8/00, G11C 11/408

(54) **Circuit décodeur de ligne pour mémoire fonctionnant sous de faibles tensions d'alimentation**
Zeilendekodierer für einen Speicher mit niedriger Versorgungsspannung
Line decoding circuit for a memory working with low power voltages

(30) Priorité: 22.12.1993 FR 9315498
(43) Date de publication de la demande: 28.06.1995
(73) Titulaire: STMicroelectronics S.A., 94250 Gentilly (FR)
(72) Inventeur: Drouot, Sylvie, F-57000 Metz (FR)
(74) Mandataire: Schmit, Christian Norbert Marie

(56) Documents cités:
- US-A- 4 692 638
- US-A- 5 202 851
- PATENT ABSTRACTS OF JAPAN vol. 16, no. 547 (P-1452) 17 Novembre 1992 & JP-A-42 005 798 (MITSUBISHI ELECTRIC CORP.)

## Description

L'invention concerne un circuit intégré décodeur de ligne pour mémoire, fonctionnant sous de faibles tensions d'alimentation.

Ce type de circuit est utilisé notamment pour sélectionner ou désélectionner les lignes de mémoires organisées matriciellement. On entend, par sélectionner ou désélectionner une ligne, le fait d'imposer une certaine tension sur cette ligne. C'est formellement un état binaire qu'on peut donc symboliser par un 0 ou un 1 logique. En pratique, on convient habituellement que sélectionner une ligne consiste à la porter à un certain potentiel positif (1 logique), et que la désélectionner consiste à la porter à un potentiel de masse (0 logique). Le potentiel positif peut néanmoins être différent selon qu'on sélectionne la ligne pour lire l'état d'une cellule ou y écrire un état.

Les mémoires comportent généralement plusieurs milliers de lignes. Quand on veut sélectionner une cellule de ces mémoires, on sélectionne une ligne de mot et une ligne de bit dont l'intersection correspond à la cellule. Si une mémoire comporte par exemple 2048 lignes au total, on peut adresser ces lignes avec un mot d'adresse sur 11 bits, notés par exemple A10 à A0. Afin de faciliter un accès rapide à ces lignes, on divise généralement la mémoire en blocs de lignes. Par exemple, on peut diviser une mémoire de 2048 lignes en 8 blocs de 256 lignes. Quand on veut accéder à une ligne, on commence alors par accéder au bloc qui contient cette ligne.

Pour faciliter le décodage des adresses de ligne à sélectionner ou désélectionner, on peut encore subdiviser ces blocs en sous-blocs, et ainsi de suite. Par exemple on peut définir une variable M représentant les bits A10 à A8, une variable L représentant les bits A7 à A4, et une variable P représentant les bits A3 à A0. Ainsi on peut montrer qu'on accélère le temps d'accès à la ligne à sélectionner.

Du fait que la variable M représente 3 bits, on pourra grouper les lignes de la mémoire en 8 blocs de 256 lignes correspondants aux 8 valeurs possibles de M (M0 à M7). De même, la variable L représentant 4 bits, les 16 valeurs possibles de L (L0 à L15) permettent de déterminer 16 sous-blocs de 16 lignes pour chacun des 8 blocs. Enfin, les 16 valeurs possibles de P (P0 à P15) permettent de déterminer les 16 lignes du sous-bloc. Ainsi chaque ligne correspondra à un triplet de valeurs du triplet de variables M, L, P.

Les lignes étant généralement longues, on pourra souhaiter ne sélectionner qu'une partie de ligne. Cela permet de se prémunir contre des effets capacitifs retardant le temps d'accès aux cellules. Par exemple, on divise les lignes en deux secteurs. Il suffit alors de définir une variable supplémentaire N de secteur correspondant à un bit prenant une valeur parmi 2, N0 et N1. On codera ainsi 4096 demi-lignes correspondant à 2048 lignes. En pratique, un décodeur de ligne d'une mémoire est placé au milieu du plan mémoire, définissant des secteurs droite et gauche, ou haut et bas.

On connaît, dans l'état de la technique, un type de circuit décodeur de ligne. Ce type de circuit décodeur de ligne comprend, pour chaque ligne, une borne d'entrée pour recevoir un signal binaire de sélection, issu typiquement d'une porte NAND à plusieurs entrées. Dans la configuration décrite précédemment, on aurait par exemple une porte NAND à trois entrées correspondantes à un triplet de valeurs des variables (N, M , L) définissant un bloc, un sous-bloc et un secteur donnés. Ainsi, une porte NAND serait reliée à 16 lignes d'un sous-bloc donné, dans un secteur donné. Il y aurait 16 portes NAND par bloc, d'où 128 portes NAND par secteur, et 256 portes NAND pour la mémoire entière. Pour un sous-bloc donné d'un secteur donné, ses 16 lignes sont chacune définies par une valeur de variable P (P0 à P15).

Pour une ligne donnée, la borne d'entrée est connectée à un transistor de sélection entre cette borne d'entrée et un inverseur dont la sortie est connectée à la ligne que sélectionne ou désélectionne ce décodeur de ligne.

Le transistor de sélection est par exemple de type N. Son drain est connecté à la borne d'entrée. La grille de commande de ce transistor est connectée à une borne de tension de sélection et sa source est connecté à l'entrée d'un inverseur. Cet inverseur comporte deux transistors de type respectivement P et N montés en série entre une borne d'alimentation de ligne et une borne de masse. La sortie de l'inverseur, constituée par les drains des deux transistors connectés entre eux, est connectée à la ligne associée au décodeur. La borne d'alimentation de ligne fournit la tension que l'on souhaite avoir sur la ligne quand elle est sélectionnée : tension de lecture ou tension d'écriture ou autre. La borne d'alimentation de ligne fournit donc un potentiel correspondant au 1 logique de sélection. Le potentiel correspondant au 0 logique de désélection sera fourni par la borne de masse. Selon la technologie employée pour réaliser la mémoire dont la ligne fait partie, la tension d'alimentation de ligne est plus ou moins importante.

L'entrée de l'inverseur, constituée par les grilles de commande des deux transistors connectées entre elles, est également connectée au drain d'un transistor de type P dont la source est connectée à la borne d'alimentation de ligne et dont la grille de commande est connectée à la sortie de l'inverseur.

Considérons par exemple une ligne correspondant à un quadruplé de valeurs (Na, Mb, Lc, Pd) des variables (N, M, L, P), avec a un entier compris entre 0 et 2, b un entier compris entre 0 et 7, c et d des entiers compris entre 0 et 15.

Si on veut sélectionner cette ligne et la porter ainsi au potentiel de la borne d'alimentation de ligne, il suffit de former le mot d'adresse sur 12 bits correspondant au quadruplé de valeurs Na, Mb, Lc, et Pd. Les signaux appliqués au circuit décodeur de la ligne et correspondant aux variables N, M, L, P passeront alors à l'état logique 1. Le transistor de sélection est alors passant et la sortie de la NAND est à 0 logique (en pratique le potentiel de masse). L'inverseur porte ainsi la ligne au potentiel souhaité par l'intermédiaire de son transistor de type P.

Si on veut désélectionner la ligne, il suffit qu'une des valeurs des variables N, M, L, ou P soit différente. Le signal correspondant à cette variable passera ainsi à l'état logique 0. La ligne en question est alors mise à la masse par le biais du transistor N de l'inverseur.

En pratique, on peut réserver un quadruplé de valeurs des variables N, M, L, P à la désélection de toutes les lignes de la mémoire. Ainsi, la désélection d'une ligne par changement de l'adresse formée n'entraînera pas la sélection d'une autre ligne correspondant à la nouvelle adresse. On pourrait également rajouter un bit d'adresse supplémentaire dont la valeur déterminerait si on procède à une sélection ou à une désélection.

Pour pouvoir tester les cellules du plan mémoire, on ajoute généralement un transistor d'isolement de type N en série avec le transistor de sélection. On connecte la grille de commande de ce transistor à la borne d'alimentation de ligne. Ainsi, lors de tests, on peut faire chuter la tension d'alimentation de ligne sans risquer de court-circuiter cette alimentation avec l'alimentation positive des portes NAND. En effet, les cellules de certaines mémoires non volatiles nécessitent de fortes tensions de commande, par exemple de 10 volts. On distingue donc la tension d'alimentation de ligne éventuellement présente sur la ligne et les tensions de sélection. Par exemple l'alimentation des circuits logiques tels que les portes NAND se fait à une tension de l'ordre de 5 volts.

Ce type de circuit présente l'inconvénient de ne pas fonctionner de manière satisfaisante à' basse tension d'entrée.

On cherche de plus en plus à avoir des produits ayant de basses tensions de sélection, de l'ordre de 3 volts par exemple.

Dans le type de décodeur décrit ci-dessus, la présence du transistor de sélection induit des pertes, entre la borne d'entrée et l'entrée de l'inverseur, dues à la tension de seuil de ce transistor. Si le transistor de sélection est de type enrichi, sa tension de seuil est de l'ordre de 1 volt, voire plus selon l'effet substrat. Il se pose alors des problèmes pour commander le transistor de type N de l'inverseur. Le temps de désélection de la ligne va croître de manière importante. On ne pourra éventuellement plus commander le transistor de type N de l'inverseur.

On pourrait envisager d'utiliser un transistor de sélection sans implants dits natif. Ce type de transistor présente une faible tension de seuil, de l'ordre de 0.1 à 0.4 volts. Cette solution nécessiterait cependant de procéder à la qualification de ce type de technologie, ce qui est particulièrement long et couteux.

On pourrait également envisager d'augmenter la tension de sélection par pompage. Cette solution présente l'inconvénient de nécessiter des circuits supplémentaires. On perdrait alors en ce qui concerne l'encombrement, la consommation et la fiabilité.

Au vu de ce qui précède, le but de la présente invention est de proposer un circuit décodeur de ligne capable de fonctionner pour des tensions de sélection basses sans nécessiter de pompage de ces tensions.

Dans le dispositif de l'invention, on modifie le montage d'un décodeur de ligne du type décrit précédemment en connectant le transistor de type N de l'inverseur de sortie à la borne d'entrée du circuit. On montre alors qu'on évite ainsi la chute de tension de commande du transistor de type N de l'inverseur due aux transistors de sélection. La commande de ce transistor est donc possible pour des tensions de sélection relativement faibles (toutefois supérieures à la tension de seuil de ce transistor).

Suivant l'invention, ce but est atteint par un circuit intégré comprenant un circuit décodeur de ligne muni :
- d'une borne d'entrée pour recevoir un signal de sélection binaire,
- d'une borne de sortie pour délivrer un signal de ligne binaire,
- de bornes de référence pour fournir respectivement une ou des tensions de base, une tension de sélection, une tension d'alimentation de ligne, et une tension de commande,
- d'un ou plusieurs transistors de sélection connectés en série entre la borne d'entrée et un premier inverseur, et connectés avec les grilles à la borne de tension de sélection,
- le premier inverseur comprenant un premier transistor de type P et un premier transistor de type N montés en série entre respectivement la borne de référence d'alimentation de ligne et une borne de référence de base, le premier transistor de type P étant connecté par sa grille de commande, d'une part au drain d'un deuxième transistor de type P dont la source est connectée à la borne de référence d'alimentation de ligne et dont la grille de commande est connectée à la borne de référence de commande, et d'autre part aux transistors de sélection, la borne de sortie étant connectée au point milieu du premier inverseur, caractérisé en ce que la borne d'entrée est connectée à la grille de commande du premier transistor de type N du premier inverseur.

Dans une version préférée, la borne de sortie de ce circuit est connectée au drain d'un deuxième transistor de type N dont la source est connectée à une borne de référence de base, et dont la grille de commande est connectée à la sortie d'un deuxième inverseur dont l'entrée est connectée à la borne de référence de sélection.

D'autres particularités et avantages de la présente invention apparaîtront dans la description détaillée ci-dessous d'un exemple de réalisation préféré, dans laquelle :
- la figure 1 représente un schéma électrique du circuit de base selon l'invention,
- la figure 2 représente une réalisation préférée de l'invention.

Cette description est donnée à titre indicatif et nullement limitatif.

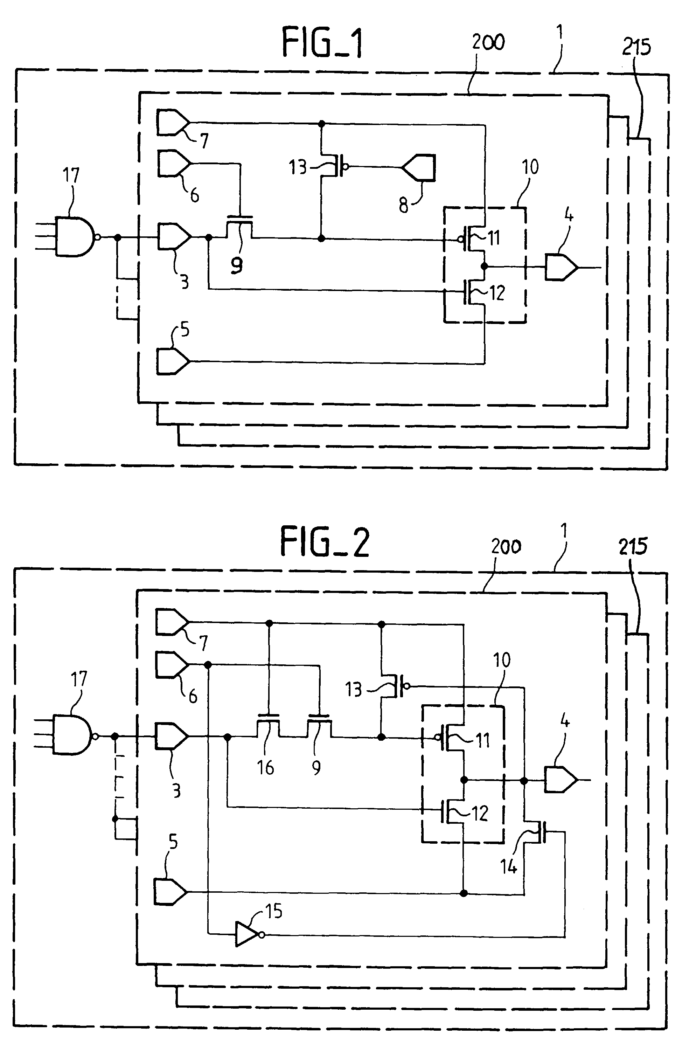

La figure 1 illustre un circuit intégré 1 comprenant des circuits décodeurs 200 à 215. Les circuits 200 à 215 sont représentés par des cadres en traits tirés juxtaposés. Par souci de clarté, les circuits 200 à 215 ne sont pas tous représentés.

Suivant l'exemple d'organisation d'une mémoire décrit précédemment, ces circuits correspondent à 16 lignes d'un sous-bloc et d'un secteur donné. Les entrées de ces 16 circuits décodeurs 200 à 215, suivant l'exemple considéré, sont connectées à la sortie d'une porte NAND 17 à plusieurs entrées (trois entrées dans la structure décrite en exemple).

Dans la suite de la description on se limitera à la description d'un seul circuit 200, étant entendu que les circuits décodeurs 200 à 215 sont structurellement identiques.

Le circuit décodeur 200 comporte :
- une borne d'entrée 3 pour recevoir un signal de sélection binaire,
- une borne de sortie 4 pour délivrer un signal de ligne binaire,
- des bornes de référence 5, 6, 7, 8 pour fournir respectivement une ou des tensions de base, une tension de sélection, une tension d'alimentation de ligne, et une tension de commande.

Le signal de sélection reçu à la borne d'entrée est fourni par la sortie de la porte NAND 17 à trois entrées. Comme on l'a vu dans l'état de la technique, la ligne est alors sélectionnée quand le signal en sortie de la porte NAND 17 est à 0 logique.

La borne de sortie 4 est connectée à une ligne associée au circuit décodeur 200.

En pratique, on utilise une borne de base 5 connectée à la masse. On pourrait néanmoins en utiliser plusieurs. Dans la suite de la description, on s'en tiendra au premier cas de figure. Quant à la tension de sélection, il s'agit pratiquement d'une tension positive d'alimentation du circuit 1 qui peut être relativement basse, de l'ordre de 3 volts, ou du potentiel de masse. Si la borne de sélection est au potentiel positif d'une alimentation du circuit 1, cela correspond à une sélection. Si la borne de sélection est au potentiel de masse, cela correspond à une désélection.

Le signal de sélection binaire prendra une valeur de 3 volts pour représenter un 1 logique, et le potentiel de masse pour représenter un 0 logique.

La tension d'alimentation de ligne et la tension positive de sélection (correspondant à une sélection) sont généralement distinctes. La tension d'alimentation de ligne est généralement supérieure à la tension de sélection, pour les mémoires non volatiles par exemple. Néanmoins, elle peut lui être inférieure, pour des séquences de test des caractéristiques des cellules mémoires par exemple.

La tension de commande est en pratique légèrement inférieure à la tension d'alimentation de ligne. Par exemple, si on considère une tension de ligne de l'ordre de 12 volts, on prendra une tension de commande de l'ordre de 10 volts. Le signal de ligne binaire prendra la valeur de la tension d'alimentation de ligne en cas de sélection. Il prendra la valeur du potentiel de la borne de base 5 en cas de désélection.

Le circuit 2 comporte par ailleurs un ou plusieurs transistors de sélection 9 connectés en série entre la borne d'entrée 3 et la borne de sortie 4. Dans l'exemple de réalisation choisi, on se contentera d'un seul transistor de sélection 9. La grille de commande de ce transistor de sélection 9 est connectée à la borne de sélection 6. Ce transistor de sélection 9, selon les valeurs de la tension appliquée à sa grille de commande d'une part et du signal de sélection binaire d'autre part, permettra de sélectionner ou de désélectionner la ligne associée au circuit décodeur 2.

Dans un premier exemple de réalisation, on connectera le drain du transistor de sélection 9 à la borne d'entrée 3.

Le circuit décodeur de ligne 2 comprend également un inverseur 10. Cette inverseur 10 comprend un premier transistor de type P 11 et un premier transistor de type N 12. Ces transistors de type P 11 et de type N 12 sont montés en série entre la borne d'alimentation de ligne 7 et la borne de base 5.

Une connexion en série de deux transistors est une connexion par leurs régions actives : drain à drain ou drain à source. Dans l'inverseur 10, on connecte ainsi les transistors de type respectivement P 11 et N 12 par leurs drains qui forment alors la sortie de l'inverseur 10. La source du transistor de type P 11 est connectée à la borne d'alimentation de ligne 7 et celle du transistor de type N 12 est connectée à la borne de base 5.

La grille de commande du transistor de type P 11 est connectée d'une part à la source du transistor de sélection 9, et d'autre part au drain d'un deuxième transistor de type P 13. La source de ce deuxième transistor de type P 13 est connectée à la borne d'alimentation de ligne 7 et sa grille de commande est connectée à la borne de commande 8.

La grille de commande du premier transistor de type N 12 est connectée à la borne d'entrée 3.

On sélectionne la ligne en fournissant un signal binaire de sélection à 0 logique (tension de masse) et une tension de sélection correspondant à 1 logique (3 volts dans l'exemple choisi). Le transistor de type N 12 de l'inverseur est alors bloqué tandis que le transistor de sélection 9 est passant. Le transistor de type P 11 de l'inverseur 10 est alors passant et relie la borne de sortie 4 à l'alimentation de ligne.

On désélectionne en fournissant un signal binaire de sélection à 1 logique et une tension de sélection à 0 logique. Le transistor de type N 12 de l'inverseur 10 devient donc passant et relie ainsi la borne de sortie 4 à la masse. Par ailleurs le transistor de sélection 9 est alors bloqué. Le deuxième transistor de type P 13 relie alors la grille de commande du premier transistor de type P 11 à la borne de sélection 7, ce qui bloque ce transistor 11.

On peut améliorer ce montage. Effectivement :
- Si, alors que la ligne est sélectionnée, la tension de sélection passe à 0 logique alors que le signal binaire de sélection reste au 0 logique , on a une sortie flottante sur la ligne.
- Dans le mode de fonctionnement décrit, le deuxième transistor de type P 13 est toujours passant, ce qui nécessite d'avoir un transistor résistif pour limiter la consommation.
- Enfin, si la tension d'alimentation de ligne chute, par exemple pour effectuer des tests sur les cellules mémoires, il n'y a plus d'isolation entre celle-ci et la tension de sélection dans le cas où le deuxième transistor de type P 13 est passant et où la borne d'entrée 3 est elle-même connectée à un transistor de type P passant dont la source est connectée à la tension de sélection au niveau 1 logique (3 volts). Cela peut se produire si la borne d'entrée 3 est connectée à la sortie d'une porte NAND 17 alimentée positivement comme on l'a précisé dans l'état de la technique.

Ces inconvénients sont surmontés grâce à des solutions représentées sur la figure 2.

On remédie au premier inconvénient en connectant la borne de sortie 4 au drain d'un deuxième transistor de type N 14 dont la source est connectée à la borne de référence de base 5 et dont la grille de commande est connectée à la sortie d'un inverseur 15 dont l'entrée est connectée à la borne de sélection 6. Dans le cas où on a plusieurs transistors de sélection, on ajoutera bien sûr autant de transistors de type N en sortie, chacun de ces transistors correspondant à un transistor de sélection.

Par rapport à un circuit décodeur de l'état de la technique, la structure suivant l'invention est à peine plus grosse (un transistor en plus si on a un transistor de sélection). Un circuit décodeur selon l'invention peut donc tenir dans la largeur d'une ligne.

On remédie au deuxième inconvénient en connectant la grille de commande du deuxième transistor de type P 13 à la borne de sortie 4. La tension de commande est alors égale à la tension présente au niveau de la borne de sortie 4. Ainsi, le transistor 13 ne consomme qu'en régime transitoire au moment des changements d'état de la ligne. Si cette solution est satisfaisante d'un point de vue fonctionnelle, elle peut s'avérer difficile à mettre en oeuvre. En effet, les lignes sont d'une épaisseur faible, par exemple de 1.7 micromètre. Il n'est alors pas évident de créer cette connexion qui forme un rebouclage.

Quant au troisième inconvénient, on s'en affranchit en connectant en série un transistor d'isolement avec le transistor de sélection 9. Par exemple on connecte un transistor de type N 16 entre la borne d'entrée 3 et le drain du transistor de sélection 9. De préférence, la connexion de la grille de commande du transistor de type N 12 à la borne d'entrée 3 se fera en amont de ce transistor d'isolement et non pas entre le transistor d'isolement 16 et le transistor de sélection 9. De cette façon, le transistor d'isolement 16 ne perturbera pas la commande du transistor de type N 12 de l'inverseur 10. On connecte alors le drain du transistor de sélection 9 à la source du transistor d'isolement 16 et le drain dudit transistor d'isolement 16 à la borne d'entrée 3. La grille de commande du transistor d'isolement 16 est connectée à la borne d'alimentation de ligne 7. Bien sûr, on déconnecte alors cette borne d'entrée 3 du drain du transistor de sélection 9.

La présence du transistor d'isolement 16 permet de diminuer, intentionnellement et sans risque, la tension d'alimentation de ligne. Cette diminution permet de déterminer les caractéristiques des cellules mémoires. En pratique, ce transistor d'isolement est utilisé en phase de mise au point. Il reste néanmoins présent en phase d'exploitation, car l'enlever nécessiterait de définir de nouveaux masques de fabrication et de procéder à une nouvelle qualification. Il y aurait un risque de ne pas retrouver les mêmes caractéristiques qu'avec le circuit comportant le transistor d'isolement.

Comme on l'a démontré, l'invention permet de fonctionner à de faibles tensions de sélection, même si on ne dispose que de la technologie de type enrichi. Bien sûr, elle reste aussi intéressante si on dispose de transistors natifs. En effet, le temps de désélection sera de toute façon plus rapide si on connecte directement la grille de commande du transistor de type N 12 de l'inverseur 10 à la borne d'entrée 3.

## Revendications

1. Circuit intégré (1) comprenant un circuit décodeur (200) de ligne muni :
- d'une borne d'entrée (3) pour recevoir un signal de sélection binaire,
- d'une borne de sortie (4) pour délivrer un signal de ligne binaire,
- de bornes de référence (5, 6, 7, 8) pour fournir respectivement une ou des tensions de base, une tension de sélection, une tension d'alimentation de ligne, une tension de commande,
- d'un ou plusieurs transistors de sélection (9) connectés en série entre la borne d'entrée (3) et un premier inverseur (10), et connectés avec les grilles à la borne de tension de sélection (6),
- le premier inverseur (10) comprenant un premier transistor de type P (11) et un premier transistor de type N (12) montés en série entre respectivement la borne de référence d'alimentation de ligne (7) et une borne de référence de base (5), le premier transistor de type P (11) étant connecté par sa grille de commande d'une part au drain d'un deuxième transistor de type P (13) dont la source est connectée à la borne de référence d'alimentation de ligne (7) et dont la grille de commande est connectée à la borne de référence de commande (8), et d'autre part aux transistors de sélection (9),
- la borne de sortie (4) étant connectée au point milieu du premier inverseur (10),
caractérisé en ce que
- la borne d'entrée (3) est connectée à la grille de commande du premier transistor de type N (12) du premier inverseur (10).

2. Circuit selon la revendication 1, caractérisé en ce que la borne de sortie (4) est connectée au drain d'un deuxième transistor de type N (14) dont la source est connectée à une borne de référence de base (5), et dont la grille de commande est connectée à la sortie d'un deuxième inverseur (15) dont l'entrée est connectée à la borne de référence de sélection (6).

3. Circuit selon l'une des revendications 1 à 2, caractérisé en ce que les transistors de sélection (9) sont de type N.

4. Circuit selon la revendication 3, caractérisé en ce que les transistors de sélection (9) sont de type enrichi.

5. Circuit selon l'une des revendication 1 à 4, caractérisé en ce que le circuit décodeur de ligne (200) comporte un ou plusieurs transistors d'isolement (16) connectés en série avec les transistors de sélection (9) entre la borne d'entrée (3) et le premier inverseur (10).

6. Circuit selon la revendication 5, caractérisé en ce que les transistors d'isolement (16) sont de type N.

7. Circuit selon la revendication 6, caractérisé en ce que les transistors d'isolement (16) sont de type enrichi.

8. Circuit selon l'une des revendications 1 à 7, caractérisé en ce que la borne d'entrée (3) est connectée à la sortie d'une porte logique NAND (17) à plusieurs entrées.

9. Circuit selon l'une des revendications 1 à 8, caractérisé en ce que la grille de commande du deuxième transistor de type P (13) est connectée à la borne de sortie (4).

## Claims

1. An integrated circuit (1) comprising a line decoding circuit (200) provided:
- with an input terminal (3) for receiving a binary selection signal,
- with an output terminal (4) for supplying a binary line signal,
- with reference terminals (5, 6, 7, 8) for supplying respective one or more base voltages, a selection voltage, a line supply voltage, a control voltage,
- with one or more selection transistors (9) connected in series between the input terminal (3) and a first inverter (10) and connected with the gates to the selection voltage terminal (6),
- the first inverter (10) comprising a first P-type transistor (11) and a first N-type transistor (12) connected in series between respectively the line supply reference terminal (7) and a base reference terminal (5), the first P-type transistor (11) being connected by its control gate firstly to the drain of a second P-type transistor (13), the source of which is connected to the line supply reference terminal (7) and the control gate of which is connected to the control reference terminal (8), and secondly to the selection transistors (9),
- the output tenninal (4) being connected to the middle point of the first inverter (10),
**characterised in that**
- the input terminal (3) is connected to the control gate of the first N-type transistor (12) of the first inverter (10).

2. A circuit according to Claim 1,
**characterised in that** the output terminal (4) is connected to the drain of the second N-type transistor (14), the source of which is connected to a base reference terminal (5), and the control gate of which is connected to the output of a second inverter (15), the input of which is connected to the selection reference terminal (6).

3. A circuit according to one of Claims 1 to 2,
**characterised in that** the selection transistors (9) are of type N.

4. A circuit according to Claim 3,
**characterised in that** the selection transistors (9) are of the enhancement type.

5. A circuit according to one of Claims 1 to 4,
**characterised in that** the line decoding circuit (200) comprises one or more isolation transistors (16) connected in series with the selection transistors (9) between the input terminal (3) and the first inverter (10).

6. A circuit according to Claim 5,
**characterised in that** the isolation transistors (16) are of type N.

7. A circuit according to Claim 6,
**characterised in that** the isolation transistors (16) are of the enhancement type.

8. A circuit according to one of Claims 1 to 7,
**characterised in that** the input terminal (3) is connected to the output of a NAND logic gate (17) having several inputs

9. A circuit according to one of Claims 1 to 8,
**characterised in that** the control gate of the second P-type transistor (13) is connected to the output terminal (4).

## Patentansprüche

1. Integrierter Schaltkreis (1) mit einem Zeilendecoderschaltkreis (200), der umfaßt:
einen Eingangsanschluß (3) zum Empfangen eines binären Auswahlsignals,
einen Ausgangsanschluß (4) zum Ausgeben eines binären Zeilensignals,
Referenzanschlüsse (5, 6, 7, 8), um jeweils eine oder mehrere Basisspannungen, eine Auswahlspannung, eine Zeilenversorgungsspannung, eine Steuerspannung auszugeben,
einen oder mehrere Auswahltransistoren (9), die in Reihe zwischen dem Eingangsanschluß (3) und einem ersten Wechselrichter (10) geschaltet sind und über die Gates mit dem Anschluß für die Auswahlspannung (6) verbunden sind,
wobei der erste Wechselrichter (10) einen ersten P-Transistor (11) und einen ersten N-Transistor (12) umfaßt, die in Reihe zwischen den Referenzanschluß zur Versorgung der Leitung (7) und einen Basisreferenzanschluß (5) geschaltet sind, wobei der erste P-Transistor (11) über sein Steuer-Gate einerseits mit dem Drain eines zweiten P-Transistors (13), dessen Source mit dem Zeilenversorgungsreferenzanschluß (7) verbunden ist und dessen Steuer-Gate mit dem Steuerreferenzanschluß (8) verbunden ist, und andererseits mit den Auswahltransistoren (9) verbunden ist,
wobei der Ausgangsanschluß (4) mit dem Mittelpunkt des ersten Wechselrichters (10) verbunden ist
**dadurch gekennzeichnet**, daß
der Eingangsanschluß (3) mit dem Steuer-Gate des ersten N-Transistors (12) des ersten Wechselrichters (10) verbunden ist.

2. Schaltkreis nach Anspruch 1,
**dadurch gekennzeichnet**, daß der Ausgangsanschluß (4) mit dem Drain eines zweiten N-Transistors (14) verbunden ist, dessen Source mit einem Basisreferenzanschluß (5) verbunden ist und dessen Steuer-Gate mit dem Ausgang eines zweiten Wechselrichters (15) verbunden ist, dessen Eingang mit dem Auswahlreferenzanschluß (6) verbunden ist.

3. Schaltkreis nach einem der Ansprüche 1 oder 2,
**dadurch gekennzeichnet**, daß die Auswahltransistoren (9) N-Transistoren sind.

4. Schaltkreis nach Anspruch 3,
**dadurch gekennzeichnet**, daß die Auswahltransistoren (9) vom angereicherten Typ sind.

5. Schaltkreis nach einem der Ansprüche 1 bis 4,
**dadurch gekennzeichnet**, daß der Zeilendecoderschaltkreis (200) einen oder mehrere Isolationstransistoren (16) umfaßt, die in Reihe mit den Auswahltransistoren (9) zwischen dem Eingangsanschluß (3) und dem ersten Wechselrichter (10) geschaltet sind.

6. Schaltkreis nach Anspruch 5,
**dadurch gekennzeichnet**, daß die Isolationstransistoren (16) N-Transistoren sind.

7. Schaltkreis nach Anspruch 6,
**dadurch gekennzeichnet**, daß die Isolationstransistoren (16) vom angereicherten Typ sind.

8. Schaltkreis nach einem der Ansprüche 1 bis 7,
**dadurch gekennzeichnet,** daß der Eingangsanschluß (3) mit dem Ausgang eines logischen NAND-Gatters (17) mit mehreren Eingängen verbunden ist.

9. Schaltkreis nach einem der Ansprüche 1 bis 8,
**dadurch gekennzeichnet**, daß das Steuer-Gate des zweiten P-Transistors (13) mit dem Ausgangsanschluß (4) verbunden ist.
